# EUROPÄISCHE PATENTSCHRIFT

(11) **EP 2 991 224 B1**
(45) Veröffentlichungstag und Bekanntmachung des Hinweises auf die Patenterteilung: **21.11.2018**
(21) Anmeldenummer: 14002983.6
(22) Anmeldetag: 29.08.2014
(51) Int. Cl.: H03K 3/57, B21D 26/14

(54) **Stoßstromgenerator**
High current pulse generator
Générateur de courant de choc

(43) Veröffentlichungstag der Anmeldung: 02.03.2016
(73) Patentinhaber: Technische Universität Dortmund, 44227 Dortmund (DE); Astrol Electronic AG, 5504 Othmarsingen (CH)
(72) Erfinder: Gies, Soeren, 44137 Dortmund (DE); Weddeling, Christian, 44139 Dortmund (DE); Herdt, Andreas, 44225 Dortmund (DE); Tekkaya, A. Erman, 44227 Dortmund (DE); Stöckli, Andreas, 5442 Fislisbach (CH); Forster, Franz, 5607 Hägglingen (CH)
(74) Vertreter: Cohausz Hannig Borkowski Wißgott

(56) Entgegenhaltungen:
- WO-A2-00/05813
- DE-A1-102012 109 413
- US-A- 4 628 427

## Beschreibung

Die Erfindung betrifft einen Stoßstromgenerator einer Vorrichtung zum elektromagnetischen Umformen von Werkstücken, umfassend wenigstens einen mit einer vorgegebenen ursprünglichen Polarität ladbaren Kondensator, der in einer Stromhalbwelle über eine triggerbare, die erste Stromhalbwelle durchlassende, rückwärtssperrende und im Stromnulldurchgang selbstlöschende Schaltanordnung durch eine beim Stromfluss die Werkstückumformung bewirkende Werkzeugspule entladbar und auf umgekehrte Polarität ladbar ist, wobei parallel zur Werkzeugspule und zu dem wenigstens einen Kondensator eine eine zweite Stromhalbwelle durchlassende, rückwärtssperrende und eine Induktivität aufweisende Rekuperationsanordnung liegt, mittels welcher der wenigstens eine Kondensator in der zweiten Stromhalbwelle entladbar und auf die ursprüngliche Polarität zurückladbar ist.

Die Erfindung betrifft weiterhin ein Verfahren zum Betrieb eines Stoßstromgenerators einer Vorrichtung zum elektromagnetischen Umformen von Werkstücken, bei welchem wenigstens ein mit einer vorgegebenen ursprünglichen Polarität geladener Kondensator in einer ersten Stromhalbwelle über eine getriggerte, die erste Stromhalbwelle durchlassende, rückwärtssperrende und im Stromnulldurchgang selbstlöschende Schaltanordnung durch eine beim Stromfluss die Werkstückumformung bewirkende Werkzeugspule entladen und auf umgekehrte Polarität aufgeladen wird und mit einer parallel zur Werkzeugspule und zu dem wenigstens einen Kondensator liegenden eine zweite Stromhalbwelle durchlassende, rückwärtssperrende und eine Induktivität aufweisende Rekuperationsanordnung, mittels welcher der wenigstens eine Kondensator in der zweiten Stromhalbwelle entladen und auf die ursprüngliche Polarität zurückgeladen wird.

Vorrichtungen zur elektromagnetischen Umformung von Werkstücken sind im Stand der Technik bekannt und beruhen auf dem Prinzip, eine die Werkstückumformung bewirkende Werkzeugspule mit einem hohen, kurzzeitigen, impulsartigen Strom zu beaufschlagen, um hierdurch in der Werkzeugspule ein elektromagnetisches Feld zu erzeugen, welches in einem elektrisch leitenden Werkstück Wirbelströme erzeugt, so dass sich zwischen der Werkzeugspule und dem umzuformenden Werkstück aufgrund der wirkenden, insbesondere magnetischen Felder eine Abstoßung ergibt, die zu einer Umformung des Werkstückes führt, beispielsweise wenn das Werkstück hierdurch in eine Matrize gepresst wird.

In einer solchen Vorrichtung zur elektromagnetischen Umformung von Werkstücken wirken extrem hohe Ströme von beispielsweise 10⁴ bis 10⁸ Ampere, die kurzzeitig die Wicklung der Werkzeugspule durchfließen und hierdurch entsprechend hohe auf das Werkstück bzw. zwischen Werkstück und Werkzeugspule wirkende Kräfte produzieren. Die elektrischen Komponenten eines solchen für den Betrieb der Vorrichtung vorgesehenen Stoßstromgenerators müssen dementsprechend für diese hohen Ströme ausgelegt sein.

Der ladbare Kondensator, der beispielsweise mittels eines Ladegerätes oder einer Ladeeinrichtung des Stoßstromgenerators auf eine vorgegebene ursprüngliche Polarität ladbar ist, bildet im Wesentlichen, sofern keinerlei stromrichtungsdefinierende Komponenten im Stoßstromgenerator vorhanden wären, mit der Induktivität der Werkzeugspule einen Schwingkreis, so dass Stoßstromgeneratoren ursprünglicher Bauart nach Schließen eines Schalters und somit startendem Entladevorgang des Kondensators ein Verhalten aufwiesen gemäß dem eine abklingende Sinusschwingung des Stromes mit aufeinanderfolgenden in der Amplitude abnehmenden Stromhalbwellen erzeugt ist. Aufeinanderfolgende Stromhalbwellen haben dabei umgekehrte Stromflußrichtungen.

Bei dem Betrieb solcher ursprünglicher Stoßstromgeneratoren zeigte sich, dass eine wirksame Beschleunigung des Werkstückes durch die Kraftwirkung des elektromagnetischen Wechselfeldes lediglich im zeitlichen Bereich der ersten Stromhalbwelle erfolgt, da zum einen bereits nach der Umformung während dieser ersten Halbwelle sich das Werkstück örtlich verlagert hatte und aus dem Einflussbereich des Magnetfeldes, beispielsweise einer zweiten oder auch späteren Stromhalbwelle weiter herausgetreten ist und des Weiteren auch die maximalen Stromhöhen der zweiten und folgenden Halbwellen gegenüber der ersten Stromhalbwelle signifikant reduziert sind.

Im Wesentlichen war daher ein Großteil der Energie, die ein Stoßstromgenerator ursprünglicher Bauart nach der ersten Stromhalbwelle grundsätzlich noch bereithält, für die Umformung eines Werkstückes nur wenig bis gar nicht nutzbar. Die Energie war darüber hinaus aufgrund des Ausschwingens des zwischen dem wenigstens einen Kondensator und der Werkzeugspule gebildeten Schwingkreises im Wesentlichen verloren und führt zudem zu einer verstärkten thermischen und mechanischen Belastung der Werkzeugspule.

Die Publikation DE 2205981 zeigt eine Schaltungsanordnung der eingangs genannten gattungsgemäßen Art, die den Betrieb einer Vorrichtung zum elektromagnetischen Umformen von Werkstücken derart ermöglichen soll, dass ein Stromfluss durch die Werkzeugspule nach dem Start des Entladevorganges des Kondensators nur während der ersten Stromhalbwelle erfolgt, die durch das Verhalten des Schwingkreises definiert ist, der durch den wenigstens einen Kondensator und die Werkzeugspule sowie gegebenenfalls weiterer, in dem Stromkreis liegende, elektrischer Komponente definiert ist.

Die in dieser Publikation offenbarte Schaltanordnung weist weiterhin parallel zu dem wenigstens einen Kondensator und der Werkzeugspule liegend eine Rekuperationsanordnung mit einer Induktivität auf, die weiterhin durch eine Diode, die in Reihe zur Induktivität liegt, für eine zweite Stromhalbwelle, die auf die erste mit umgekehrter Stromrichtung relativ zum Kondensator folgt, durchlässig und in rückwärtiger Richtung sperrend ist, wobei diese zweite Stromhalbwelle dadurch erzeugt wird, dass der während der ersten Stromhalbwelle bei der Werkstückumformung entladene und mit umgekehrter Polarität aufgrund des Schwingkreisverhaltens wieder aufgeladene Kondensator nun aufgrund der umgekehrten Polarität einen Stromfluss durch die Induktivität der Rekuperationsanordnung und die in rückwärtiger Richtung sperrende Diode zulässt, so dass durch die Rekuperationsanordnung und dem wenigstens einen Kondensator ein zweiter Schwingkreis erzeugt ist, der eine Zurückladung des Kondensators auf seine ursprünglich vorgegebene Polarität mit gegenüber dem ursprünglichen Ladungsniveau verringerten Ladungsinhalt ermöglicht, hierdurch also die in den beiden gekoppelten Schwingkreisen enthaltene Energie in korrekter ursprünglicher Polarität in den wenigstens einen Kondensator zurückführt, um diese Energie für später folgende Werkstückumformungen erneut zu nutzen, beispielsweise dadurch, dass lediglich die während der Werkstückumformung verbrauchte Energie in den Kondensator nachgeladen wird und dieser sodann erneut für eine Werkstückumformung durch die Werkzeugspule entladen wird.

In der Praxis zeigt sich bei der bekannten Schaltungsanordnung der Rekuperationsanordnung des Standes der Technik, dass ein einwandfreies Funktionieren des dort offenbarten Stoßstromgenerators nicht möglich ist, da die Rekuperationsanordnung, die für die zweite Stromhalbwelle durchlässig ist, bereits unmittelbar anschließend an den Nulldurchgang der ersten Stromhalbwelle aufgrund der passiven Diode stromdurchlässig ist, da bereits zu diesem Zeitpunkt eine zur ursprünglichen Polarität umgekehrte Polarität am Kondensator anliegt, was zu einer Entladung des Kondensators durch die Rekuperationsanordnung führt, unter Berücksichtigung des zwischen dem wenigstens einen Kondensators und der Rekuperationsanordnung gebildeten Schwingkreisverhaltens. Das Dokument US 4,628,427 zeigt eine Schaltungsanordnung zur Erzeugung von Stromimpulsen umfassend einen Kondensator, der parallel zu einer Reihenschaltung von einer Induktivität und einem Thyristor angeordnet ist.

Die im Stand der Technik und auch bei der vorliegenden Erfindung eingesetzten selbstlöschenden Schaltanordnungen bewirken, dass diese nach Durchlaufen des Nulldurchganges den durch sie hindurch erfolgenden Stromfluss unterbrechen bzw. abschalten, wofür jedoch die Schaltanordnungen, wie zum Beispiel Thyristoren oder Thyratrons eine gewisse Freiwerdezeit nach dem Nulldurchgang benötigen, bis dass diese erneut durch zum Beispiel einen Triggerimpuls gezündet werden können.

Wird nun gemäß des Standes der Technik jedoch die mit umgekehrter Stromrichtung fließende zweite Stromhalbwelle bereits zur Zeit des Nulldurchganges, kurzzeitig danach oder ggfs. sogar schon zuvor erzeugt, so wird die für die erste Stromhalbwelle durchlässige, rückwärtssperrende Schaltanordnung bereits aus der zweiten Stromhalbwelle mit Ladungsträgern beaufschlagt, so dass die Wirkung des Selbstlöschens und damit das Abschalten nicht oder nur undefiniert eintritt.

Es kann daher mit der Schaltanordnung des Standes der Technik nicht verhindert werden, dass zumindest ein Teil der Energie, die im umgepolten Kondensator bzw. der zweiten Stromhalbwelle gespeichert ist, noch durch die Werkzeugspule verloren geht, ohne für die Rückladung des Kondensators auf die ursprüngliche vorgegebene Polarität genutzt zu werden und/oder zu einer starken thermischen und mechanischen Belastung der Werkezugspule führt.

Es ist daher die Aufgabe der Erfindung, eine Schaltanordnung der eingangs genannten gattungsgemäßen Art und ein Verfahren der eingangs genannten gattungsgemäßen Art derart weiterzubilden, dass eine verbesserte Energierekuperation möglich ist, insbesondere jederzeit im Betrieb des Stoßstromgenerators definierte Schaltzustände der Schaltanordnung vorliegen.

Diese Aufgabe wird gemäß der unabhängigen Ansprüchen 1 und 10 dadurch gelöst, dass bei dem Stoßstromgenerator bzw. dem Verfahren der eingangs genannten gattungsgemäßen Art die Rekuperationsanordnung in einem definierten, insbesondere vorgegebenen zeitlichen Abstand zum Nulldurchgang der ersten Stromhalbwelle getriggert geschaltet ist bzw. geschaltet wird.

Hierbei ist es der wesentliche Kerngedanke der Erfindung, in der für die zweite Stromhalbwelle durchlässigen, rückwärtssperrenden und eine Induktivität aufweisenden Rekuperationsanordnung den Stromfluss nicht undefiniert jederzeit dann beginnen zu lassen, wenn der wenigstens eine Kondensator eine für diese zweite Stromhalbwelle genügende Ladung korrekter Polarität, das heißt am Ende der ersten Stromhalbwelle bereitstellt, sondern erst dann, wenn durch einen ausdrücklichen Triggerimpuls ein Schalter innerhalb der Rekuperationsanordnung geschaltet wird. Ein solcher Triggerimpuls kann durch eine übergeordnete Steuerung bereitgestellt werden.

So besteht hierdurch die Möglichkeit, den Triggerimpuls, der das getriggerte Schalten der Rekuperationsanordnung mittels eines Schalters, wie beispielsweise eines Thyristors, bewirkt, zeitlich so zu legen, dass sich ein genügend großer zeitlicher Abstand zum Nulldurchgang der ersten die Werkstückumformung bewirkenden Stromhalbwelle ergibt und somit innerhalb dieses zeitlichen Abstandes das Selbstlöschen der die erste Stromhalbwelle durchlassenden rückwärtssperrenden Schaltanordnung mit Sicherheit erfolgt ist, also der mögliche Stromfluss durch diese unterbrochen ist.

Erfindungsgemäß erfolgt ein Triggerimpuls zum Schalten der Rekuperationsanordnung nach dem Nulldurchgang zeitlich erst dann, wenn die sogenannte Freiwerdezeit der vorgenannten Schaltanordnung überschritten ist.

Um eine getriggerte Schaltung der Rekuperationsanordnung zu ermöglichen, die parallel zu dem wenigstens einen Kondensator und der Werkzeugspule liegt, kann beispielsweise vorgesehen sein, zusätzlich zur in der Rekuperationsanordnung vorgesehenen Induktivität, wie beispielsweise einer Spule, einen getriggerten, im Stromnulldurchgang selbstlöschenden und rückwärtssperrenden Schalter, wie beispielswiese einen Thyristor einzusetzen oder alternativ einen selbstlöschenden Schalter und eine rückwärtssperrende Diode. So wird hierdurch der Kondensator in seinem zurückgeladenen Zustand gehalten, ohne dass wiederum eine Stromhalbwelle, insbesondere eine dritte Halbwelle generiert wird, da nach der Rückladung sowohl die Rekuperationsanordnung als auch die eingangs genannte Schaltanordnung stromsperrend geschaltet sind.

Hier ist demnach ein solcher selbstlöschender, rückwärtssperrender Schalter derart angeordnet, dass dieser für die zweite Stromhalbwelle durchlässig und in der rückwärtigen Richtung sperrend ist.

Der Einsatz von beispielsweise Thyristoren in der Rekuperationsschaltung ist üblicherweise problemlos möglich, da keine Notwendigkeit besteht, mittels des in der Rekuperationsschaltung angeordneten Schalters derart hohe Ströme mit derart kurzen Stromanstiegszeiten zu schalten, wie dies für die Werkstückumformung nötig ist. Es kann daher in einer Rekuperationsschaltung auf kommerziell weitläufig erhältliche Schalter, wie beispielsweise Thyristoren, zurückgegriffen werden.

Um dies zu erzielen, kann es insbesondere in einer bevorzugten Weiterbildung vorgesehen sein, dass beispielsweise durch Auswahl der Induktivität in der Rekuperationsschaltung in Relation zur Werkzeugspule die Stromanstiegszeit der zweiten Stromhalbwelle größer ist als in der ersten Stromhalbwelle. Die zeitliche Dauer der zweiten Stromhalbwelle wird bevorzugt länger eingestellt als die Zeit der ersten Stromhalbwelle.

Da demgegenüber für die Werkstückumformung extrem hohe Ströme innerhalb sehr kurzer Zeiten geschaltet werden müssen, kann die Notwendigkeit bestehen, in der triggerbaren, die erste Stromhalbwelle durchlassenden, rückwärtssperrenden und im Stromnulldurchgang selbstlöschenden Schaltordnung, einen im Stromnulldurchgang selbstlöschenden Schalter einzusetzen, der selbst nicht rückwärtssperrend ist, und einen solchen Schalter in einer Reihenschaltung mit einer rückwärtssperrenden Diode zu kombinieren.

Hier gewährleistet demnach die Diode, dass die erste Stromhalbwelle durchgelassen, eine Stromhalbwelle in rückwärtige Richtung, wie beispielsweise die zweite Stromhalbwelle hingegen gesperrt wird.

Eine solche Auftrennung der Schaltanordnung für die erste Stromhalbwelle in wenigstens zwei elektrische beziehungsweise elektronische Bauelemente bietet den Vorteil, jedes der Bauelemente individuell hinsichtlich der Stromhöhen und Stromanstiegszeiten auswählen zu können.

Es können insbesondere hierdurch auch im Stromnulldurchgang selbstlöschende Schalter verwendet werden, die in beide Richtungen stromdurchlässig sind, da solche Schalter auch für deutlich höhere Stromstärken und Stromanstiegsgeschwindigkeiten zur Verfügung stehen als solche Schalter, die in einer rückwärtigen Richtung sperrend ausgelegt sind.

Eine mögliche Weiterbildung des erfindungsgemäßen Stoßstromgenerators kann es vorsehen, dass bei einer für die erste Stromhalbwelle durchlässigen selbstlöschenden Schaltanordnung der vorbeschriebenen Art, die aus einer stromrichtungsdefinierenden Diode und einem selbstlöschenden Schalter, wie beispielsweise einem Thyristor oder Thyratron aufgebaut ist, der Stromeingang der Werkzeugspule von dem Ausgang der Diode direkt auf den Ausgang des selbstlöschenden Schalters schaltbar ist. Hierdurch ist der Stoßstromgenerator der erfindungsgemäßen Art in seiner Betriebsweise umschaltbar, nämlich derart, dass durch die vorbeschriebene Schaltmöglichkeit ein Ausschwingen des Stoßstromgenerators gemäß ursprünglichem Stand der Technik ermöglicht ist.

Sofern bei der selbstlöschenden Schaltanordnung für die erste Stromhalbwelle weiterhin auch ein rückwärtssperrender Schalter in Kombination mit einer in Stromflussrichtung folgenden Diode eingesetzt wird, kann es ergänzend vorgesehen sein, dass der Ausgang der Diode auf den Eingang des Schalters schaltbar ist, um sodann in rückwärtiger Stromrichtung, das heißt für die zweite und jeweils weitere gerade Stromhalbwelle, die genannte Diode aufgrund dieser Verschaltung in einem Bypass um den rückwärtssperrenden Schalter herum angeordnet ist.

Bei allen möglichen Ausführungen der vorbeschriebenen Erfindung kann es vorgesehen sein, dass in einer ersten möglichen Betriebsvariante die Rekuperationsschaltung, das heißt insbesondere der darin vorgesehene triggerbare Schalter und bevorzugt der rückwärtssperrende und selbstlöschende triggerbare Schalter mit einer fest vorgegebenen zeitlichen Verzögerung nach dem Triggerzeitpunkt der die erste Stromhalbwelle durchlassenden Schaltanordnung getriggert ist. Es wird hierdurch ein fester Triggerzeitpunkt für die Rekuperationsschaltung bereitgestellt, der abhängig ist vom Triggerzeitpunkt, zu welchem der Stromfluss der ersten Stromhalbwelle durch die Werkzeugspule initiiert wird.

Beispielsweise kann es vorgesehen sein, mit dem Trigger der die erste Stromhalbwelle schaltenden Schaltanordnung einen zeitlichen Zähler in Gang zu setzen, der eine vorbestimmte Zeitdauer zählt und hiernach einen Triggerimpuls für die Rekuperationsanordnung erzeugt.

Die vorbestimmte Zeitdauer ist demnach dann derart zu bemessen, dass sich hierdurch eine fest vorgegebene zeitliche Verzögerung zwischen den beiden jeweiligen Triggerzeitpunkten von Schaltanordnung und Rekuperationsanordnung ergibt, nach welcher nicht nur der Nulldurchgang der ersten Stromhalbwelle aufgetreten ist, sondern zusätzlich auch eine Zeit abgelaufen ist, die größer ist, als die sogenannte Freiwerdezeit des selbstlöschenden Schalters der vorgenannten Schaltanordnung für die erste Stromhalbwelle.

Um eventuelle Unwägbarkeiten hinsichtlich des zeitlichen Auftretens des Stromnulldurchganges der ersten Stromhalbwelle auszuräumen, kann es in einer anderen Ausführung auch vorgesehen sein, dass die Rekuperationsschaltung mit einer fest vorgegebenen zeitlichen Verzögerung nach dem messtechnisch erfassten Stromnulldurchgang, der die erste Stromhalbwelle durchlassenden Schaltanordnung getriggert ist.

Hierdurch wird sichergestellt, dass unabhängig von der tatsächlichen zeitlichen Lage des Stromnulldurchganges dieser Stromnulldurchgang tatsächlich zunächst auftritt, messtechnisch erfasst wird und erst ab diesem messtechnisch erfassten Stromnulldurchgangsereignis eine zeitliche Verzögerung abgewartet wird, die mindestens so groß ist wie die Freiwerdezeit des selbstlöschenden Schalters, nach welcher also der selbstlöschende Schalter mit Sicherheit die Möglichkeit des Stromflusses durch ihn hindurch nach dem Stromnulldurchgang unterbrochen hat.

Beispielsweise kann diese zeitliche Verzögerung mit einem Sicherheitszuschlag versehen sein, bezogen auf die sogenannte Freiwerdezeit, die beispielsweise einem Datenblatt des verwendeten selbstlöschenden Schalters zu entnehmen ist.

Die messtechnische Erfassung des Stromnulldurchganges von der ersten die Werkzeugumformung bewirkenden Stromhalbwelle kann besonders bevorzugt berührungslos erfolgen, wie z. B. mittels einer sogenannten Rogowski-Sonde, um somit zumindest keine wesentliche Beeinflussung des Schwingkreisverhaltens zwischen dem wenigstens einen Kondensator und der Werkzeugspule zu erzeugen. Die messtechnische Erfassung kann von einer übergeordneten Steuerung vorgenommen werden, welche auch die Triggerung der Rekuperationsanordnung vornimmt.

Eine weitere Ausführung der Erfindung kann es auch vorsehen, das tatsächlich erfolgte Selbstlöschen des Schalters in der für die erste Stromhalbwelle durchlässigen Schaltanordnung messtechnisch zu erfassen, um konkret hiernach den Triggerimpuls für die Rekuperationsschaltung zum Beispiel unmittelbar danach auszulösen. Beispielsweise kann es hierfür vorgesehen sein, in einem selbstlöschenden Schalter dieser Schaltanordnung die die Stromdurchlässigkeit bewirkende Raumladungszone der aneinandergrenzenden Halbleiterzonen zu überwachen und erst nach konkretem Abbau der dortigen Raumladung die Triggerung der Rekuperationsanordnung, insbesondere also die Triggerung von deren, bevorzugt selbstlöschenden und weiter bevorzugt auch rückwärtssperrenden Schalter zu bewirken.

Ausführungsformen der Erfindung werden anhand der nachfolgend beschriebenen Figuren diskutiert.

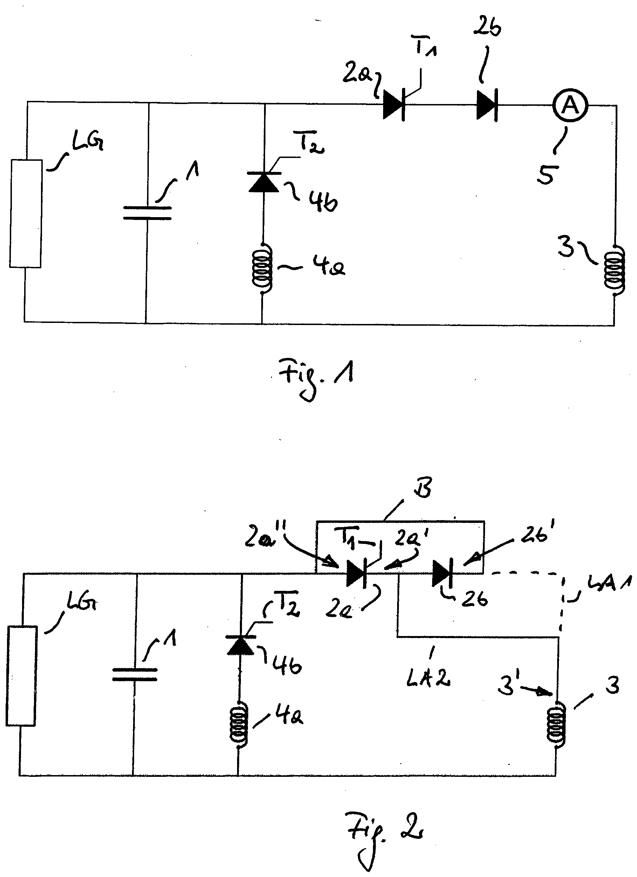

Die Figur 1 zeigt in einer schematischen Darstellung der elektrischen Ersatzschaltbilder einen Stoßstromgenerator der erfindungsgemäßen Art. Mittels eines hier symbolisch dargestellten Ladegerätes LG, dessen Darstellung nicht mit einer Widerstandsdarstellung zu verwechseln ist, ist es vorgesehen, den Kondensator 1 mit einer bestimmten Ladung einer vorgegebenen ursprünglichen Polarität zu versehen.

Der Kondensator 1 bildet mit der Werkzeugspule 3 die für die Umformung eines hier nicht gezeigten Werkstückes vorgesehen ist, einen Schwingkreis mit einem bestimmten Schwingverhalten und kann über die Schaltanordnung aus den Bauelementen 2a und 2b entladen und gemäß dem Schwingkreisverhalten innerhalb der ersten Stromhalbwelle auf umgekehrte Polarität wieder aufgeladen werden.

Hierfür ist es vorgesehen, den selbstlöschenden und nicht zwingend rückwärtssperrenden Schalter 2a an seinem Triggereingang T₁ mit einem Triggerimpuls zu beaufschlagen, so dass dieser zündet, das heißt niederohmig wird und einen Stromfluss zwischen den Kondensatorkontakten durch die Werkzeugspule 3 und durch die hier nachgelagerte Diode 2b ermöglicht.

Bei der hier dargestellten Schaltanordnung aus den Elementen 2a und 2b bildet zumindest die Diode 2b ein rückwärtssperrendes stromrichtungsdefinierendes Element, welches sicherstellt, dass nur die erste Stromhalbwelle durch diese Schaltanordnung aus den Komponenten 2a und 2b durchgelassen wird. Innerhalb dieser Stromhalbwelle wird demnach die Werkzeugspule 3 bestromt und kann die Umformung des hier nicht dargestellten Werkstückes vornehmen.

Aufgrund der rückwärtssperrenden Wirkung zumindest der Diode 2b, ggfs. auch des Schalters 2a kann der am Ende der ersten Stromhalbwelle mit umgekehrter Polarisation geladene Kondensator 1 nicht in rückwärtiger Richtung durch die Werkzeugspule 3 und die Schaltanordnung 2a und 2b entladen werden. Weiterhin ist die Wirkung derart, dass aufgrund des selbstlöschenden Verhaltens des Schalters 2a, wie beispielsweise eines Thyristors, ab dem Nulldurchgang der ersten Stromhalbwelle, dieser wiederum hochohmig wird, also selbstlöschend ist und somit die Möglichkeit des Stromflusses durch ihn hindurch abschaltet, wofür jedoch der Schalter 2a eine gewisse Zeit nach dem Nulldurchgang, die sogenannte Freiwerdezeit, benötigt.

Erfindungsgemäß ist nun parallel zum Kondensator 1 und zur Werkzeugspule 3 eine Rekuperationsanordnung aus einer Induktivität 4a und einem triggerbaren rückwärtssperrenden Schalter 4b, wie beispielsweise einem Thyristor, vorgesehen.

Gemäß der Erfindung wird nun der Schalter 4b erst dann an seinem Triggereingang T₂ angetriggert und schaltet den Stromfluss zwischen den Kontakten des Kondensators 1 durch die Induktivität 4a hindurch erst dann, wenn der selbstlöschende Schalter 2a den Stromfluss durch ihn hindurch definitiv unterbrochen hat.

So wird die in umgekehrter Richtung laufende zweite Stromhalbwelle, deren zeitliches Verhalten durch das Schwingkreisverhalten zumindest des Schwingkreises aus Kondensator 1 und Induktivität 4a gebildet ist, erst dann initiiert, wenn ein Stromfluss durch die Schaltanordnung 2a, 2b nicht mehr möglich ist.

Die erzeugte zweite Stromhalbwelle, die ein Umladen des Kondensators 1 auf seine ursprüngliche vorgegebene Polarität mit reduziertem Ladungsniveau bewirkt, hat somit keinerlei Auswirkung auf die Schaltfunktion des selbstlöschenden Schalters 2a, da dieser vor der Auslösung der zweiten Stromhalbwelle seinen definierten, gelöschten Zustand bereits erreicht hat.

Die Figur 1 sieht hier vor, dass mit einem Strommessmittel 5, bevorzugt berührungslos und beispielsweise mit einer Rogowski-Sonde, der Strom durch die Werkzeugspule 3 messtechnisch überwacht wird, um so den Stromnulldurchgang nach der ersten Stromhalbwelle definitiv festzustellen.

Ausgehend von dem festgestellten Stromnulldurchgang kann es nun vorgesehen sein, dass eine gewisse vorgegebene Zeit abgewartet wird, bis dass der Triggerimpuls an den Schalter 4b angelegt wird, z.B. durch eine hier nicht gezeigte Steuerung, die den Stromnulldurchgang feststellt.

Hierfür kann ein entsprechender Zeit-Zähler in der übergeordneten Steuerung vorgesehen sein, der eine vorbestimmte Zeitdauer zählt und erst dann gestartet wird, wenn der Nulldurchgang detektiert ist. Die vorbestimmte Zeitdauer bzw. Verzögerung ist sodann derart gewählt, dass diese zumindest größer ist als die sogenannte Freiwerdezeit des Schalters 2a, das heißt diejenige Zeit, die dieser Schalter nach Nulldurchgang für das definitive Erreichen der sperrenden, das heißt hochohmigen Zustandes benötigt.

Die Figur 2 zeigt eine Weiterbildung der erfindungsgemäßen Schaltung, gemäß welcher diese Schaltung in einen Betriebszustand zurückversetzt werden kann, in welcher die Schaltung ein ausschwingendes Verhalten durch aufeinanderfolgende Stromhalbwellen zeigt, die alle durch die Werkzeugspule 3 hindurchlaufen, insbesondere hierbei die Rekuperationsanordnung aus den Elementen 4a und 4b nicht wirkt.

Hierfür ist es zumindest vorgesehen, den gestrichelten Leitungsabschnitt LA1 schaltungstechnisch aufzutrennen, also die Ausgangsseite 2b' der Diode 2b von der Eingangsseite 3' der Werkzeugspule 3 zu trennen und die Eingangsseite 3' der Werkzeugspule über den Leitungsabschnitt LA2 direkt auf den Ausgang 2a' des Schalters 2a aufzuschalten.

Sofern der Schalter 2a selbstlöschend und nicht rückwärtssperrend ist, lässt dieser unmittelbar zu, dass alle Stromhalbwellen, unabhängig von ihrer Stromrichtung, durch diesen Schalter passieren können und somit das Gesamtsystem ausschwingt.

Ist hingegen als Schalter 2a ein in rückwärtiger Richtung sperrender Schalter eingesetzt, so kann es ergänzend vorgesehen sein, den Ausgang 2b' der Diode 2b auf den Eingang 2a" des Schalters 2a aufzuschalten und hierdurch einen Bypass B zu bilden, durch welchen zumindest diejenigen Stromhalbwellen am Schalter 2a vorgeführt werden, für welche der Schalter 2a sperrend ist.

Sofern hingegen der Schalter 2a keine rückwärtssperrende Eigenschaft hat, kann der Bypass B entfallen.

Ein Stoßstromgenerator gemäß der Figur 2 mit der Umschaltmöglichkeit zwischen den Leitungsabschnitten LA1 und LA2, das heißt der Möglichkeit, den Spuleneingang 3' alternativ auf den Diodenausgang 2b oder unmittelbar auf den Schalterausgang 2a' aufzuschalten, bietet also die Möglichkeit, den Stoßstromgenerator in einer ersten Betriebsweise zu betreiben, in welcher die Rekuperationsanordnung energierückgewinnend eingesetzt wird oder in einer zweiten Betriebsweise, in welcher der Stoßstromgenerator ausschwingend betrieben wird.

## Patentansprüche

1. Stoßstromgenerator einer Vorrichtung zum elektromagnetischen Umformen von Werkstücken umfassend wenigstens einen mit einer vorgegebenen ursprünglichen Polarität ladbaren Kondensator (1), der in einer ersten Stromhalbwelle über eine triggerbare, die erste Stromhalbwelle durchlassende, rückwärtssperrende und im Stromnulldurchgang selbstlöschende Schaltanordnung (2a, 2b) durch eine beim Stromfluss die Werkstückumformung bewirkende Werkzeugspule (3), mit der auf das Werkstück wirkende Kräfte produzierbar sind, entladbar und auf umgekehrte Polarität ladbar ist, wobei parallel zur Werkzeugspule (3) und zu dem wenigstens einen Kondensator (1) eine die in umgekehrte Richtung laufende zweite Stromhalbwelle durchlassende, rückwärtssperrende und eine Induktivität (4a) aufweisende Rekuperationsanordnung (4a, 4b) liegt, mittels der der wenigstens eine Kondensator (1) in der zweiten Stromhalbwelle entladbar und auf die ursprüngliche Polarität zurückladbar ist, wobei die Rekuperationsanordnung (4a, 4b) einen Schalter (4b) umfasst, der in einem zeitlichen Abstand zum Nulldurchgang der ersten Stromhalbwelle getriggert geschaltet ist, um den Stromfluß durch die Rekuperationsanordnung beginnen zu lassen , **dadurch gekennzeichnet, dass** der zeitliche Abstand mindestens so groß ist wie die Freiwerdezeit der selbstlöschenden Schaltanordnung (2a, 2b), nach welcher die selbstlöschende Schaltanordnung (2a, 2b) mit Sicherheit die Möglichkeit des Stromflusses durch sie hindurch nach dem Stromnulldurchgang unterbrochen hat.

2. Stoßstromgenerator nach Anspruch 1, **dadurch gekennzeichnet, dass** die Rekuperationsschaltung (4a, 4b) mittels eines getriggerten, im Stromnulldurchgang selbstlöschenden, rückwärtssperrenden Schalters (4b), bevorzugt Thyristors (4b), geschaltet ist.

3. Stroßstromgenerator nach einem der vorherigen Ansprüche, **dadurch gekennzeichnet, dass** insbesondere durch Auswahl der Induktivität (4a) in Relation zur Werkzeugspule (3), die Stromamplitude der zweiten Halbwelle kleiner ist als in der ersten Stromhalbwelle und die Stromanstiegszeit der zweiten Stromhalbwelle größer ist als in der ersten Stromhalbwelle.

4. Stroßstromgenerator nach einem der vorherigen Ansprüche, **dadurch gekennzeichnet, dass** die die erste Stromhalbwelle durchlassende, rückwärtssperrende und im Stromnulldurchgang selbstlöschende Schaltanordnung (2a, 2b) ausgebildet ist durch eine die erste Stromhalbwelle durchlassende, rückwärtssperrende Diode (2b) und einen im Stromnulldurchgang selbstlöschenden Schalter (2a).

5. Stroßstromgenerator nach Anspruch 4, **dadurch gekennzeichnet, dass** der Stromeingang (3') der Werkzeugspule (3) von dem Ausgang (2b') der Diode (2b) direkt auf den Ausgang (2a') des selbstlöschenden Schalters (2a) schaltbar ist.

6. Stroßstromgenerator nach Anspruch 5, **dadurch gekennzeichnet, dass** bei Verwendung eines rückwärtssperrenden Schalters (2a) der Ausgang (2b') der Diode (2b) auf den Eingang (2a") des Schalters (2a) schaltbar ist.

7. Stroßstromgenerator nach Anspruch 2, **dadurch gekennzeichnet, dass** die Rekuperationsschaltung (4a, 4b) mit einer fest vorgegebenen zeitlichen Verzögerung nach dem Triggerzeitpunkt der die erste Stromhalbwelle durchlassenden Schaltanordnung (2a, 2b) getriggert ist.

8. Stroßstromgenerator nach Anspruch 2, **dadurch gekennzeichnet, dass** die Rekuperationsschaltung (4a, 4b) mit einer fest vorgegebenen zeitlichen Verzögerung nach dem messtechnisch erfassten Stromnulldurchgang der die erste Stromhalbwelle durchlassenden Schaltanordnung (2a, 2b) getriggert ist.

9. Stroßstromgenerator nach Anspruch 8, **dadurch gekennzeichnet, dass** die messtechnische Erfassung (5) des Stromnulldurchganges berührungslos erfolgt, insbesondere mittels einer Rogowski-Sonde.

10. Verfahren zum Betrieb eines Stoßstromgenerators einer Vorrichtung zum elektromagnetischen Umformen von Werkstücken, bei welchem wenigstens ein mit einer vorgegebenen ursprünglichen Polarität geladener Kondensator (1) in einer ersten Stromhalbwelle über eine getriggerte, die erste Stromhalbwelle durchlassende, rückwärtssperrende und im Stromnulldurchgang selbstlöschende Schaltanordnung (2a, 2b) durch eine beim Stromfluss die Werkstückumformung bewirkende Werkzeugspule (3), mit der auf das Werkstück wirkende Kräfte produzierbar sind, entladen und auf umgekehrte Polarität aufgeladen wird und mit einer parallel zur Werkzeugspule (3) und zu dem wenigstens einen Kondensator (1) liegenden die zweite in umgekehrte Richtung laufende Stromhalbwelle durchlassende, rückwärtssperrende und eine Induktivität aufweisende Rekuperationsanordnung (4a, 4b) der wenigstens eine Kondensator (1) in der zweiten Stromhalbwelle entladen und auf die ursprüngliche Polarität zurückgeladen wird, wobei ein Schalter innerhalb der Rekuperationsanordnung (4a, 4b) in einem zeitlichen Abstand zum Nulldurchgang der ersten Stromhalbwelle getriggert geschaltet wird, um den Stromfluß durch die Rekuperationsanordnung beginnen zu lassen, **dadurch gekennzeichnet, dass** der zeitliche Abstand mindestens so groß ist wie die Freiwerdezeit der selbstlöschenden Schaltanordnung (2a, 2b), nach welcher die selbstlöschende Schaltanordnung (2a, 2b) mit Sicherheit die Möglichkeit des Stromflusses durch sie hindurch nach dem Stromnulldurchgang unterbrochen hat.

## Claims

1. Surge current generator of an apparatus for electromagnetic deformation of workpieces comprising at least one capacitor (1), which can be charged using a prescribed original polarity and which can be discharged and can be charged to reverse polarity in a first current half-wave by means of a triggerable switching arrangement (2a, 2b), which allows the first current half-wave to pass through, is reverse-blocking and, in the current zero crossing, is non-latching, by way of a tool coil (3), which causes the workpiece deformation in the case of a flow of current and which can be used to produce forces that act on the workpiece, wherein a recuperation arrangement (4a, 4b), which allows the second current half-wave running in the reverse direction to pass through, is reverse-blocking and has an inductance (4a), is situated parallel to the tool coil (3) and to the at least one capacitor (1), by means of which recuperation arrangement the at least one capacitor (1) can be discharged and recharged to the original polarity in the second current half-wave, wherein the recuperation arrangement (4a, 4b) comprises a switch (4b), which is switched in a triggered manner at a time interval with respect to the zero crossing of the first current half-wave in order to allow the flow of current through the recuperation arrangement to begin, **characterized in that** the time interval is at least as long as the recovery time of the non-latching switching arrangement (2a, 2b), after which recovery time the non-latching switching arrangement (2a, 2b) has definitely interrupted the possibility for the current to flow through said switching arrangement after the current zero crossing.

2. Surge current generator according to Claim 1, **characterized in that** the recuperation circuit (4a, 4b) is switched by means of a triggered, reverse-blocking switch (4b), preferably a thyristor (4b), which switch, in the current zero crossing, is non-latching.

3. Surge current generator according to either of the preceding claims, **characterized in that,** in particular through selection of the inductance (4a) in relation to the tool coil (3), the current amplitude of the second half-wave is lower than in the first current half-wave and the current rise time of the second current half-wave is greater than in the first current half-wave.

4. Surge current generator according to one of the preceding claims, **characterized in that** the switching arrangement (2a, 2b), which allows the first current half-wave to pass through, is reverse-blocking and, in the current zero crossing, is non-latching, is formed by a reverse-blocking diode (2b), which allows the first current half-wave to pass through, and a switch (2a), which, in the current zero crossing, is non-latching.

5. Surge current generator according to Claim 4, **characterized in that** the current input (3') of the tool coil (3) can be switched from the output (2b') of the diode (2b) directly to the output (2a') of the non-latching switch (2a).

6. Surge current generator according to Claim 5, **characterized in that,** when a reverse-blocking switch (2a) is used, the output (2b') of the diode (2b) can be switched to the input (2a") of the switch (2a).

7. Surge current generator according to Claim 2, **characterized in that** the recuperation circuit (4a, 4b) is triggered with a fixedly prescribed time delay after the trigger time of the switching arrangement (2a, 2b), which allows the first current half-wave to pass through.

8. Surge current generator according to Claim 2, **characterized in that** the recuperation circuit (4a, 4b) is triggered with a fixedly prescribed time delay after the metrologically detected current zero crossing of the switching arrangement (2a, 2b), which allows the first current half-wave to pass through.

9. Surge current generator according to Claim 8, **characterized in that** the metrological detection (5) of the current zero crossing is performed in a contactless manner, in particular by means of a Rogowski probe.

10. Method for operating a surge current generator of an apparatus for electromagnetic deformation of workpieces, in which at least one capacitor (1), which is charged using a prescribed original polarity, is discharged and charged to reverse polarity in a first current half-wave, by means of a triggered switching arrangement (2a, 2b), which allows the first current half-wave to pass through, is reverse-blocking and, in the current zero crossing, is non-latching, by way of a tool coil (3), which causes the workpiece deformation in the case of a flow of current and which can be used to produce forces that act on the workpiece, and the at least one capacitor (1) is discharged and recharged to the original polarity in the second current half-wave using a recuperation arrangement (4a, 4b), which allows the second current half-wave running in the reverse direction to pass through, is reverse-blocking, has an inductance and is situated parallel to the tool coil (3) and to the at least one capacitor (1), wherein a switch inside the recuperation arrangement (4a, 4b) is switched in a triggered manner at a time interval with respect to the zero crossing of the first current half-wave in order to allow the flow of current through the recuperation arrangement to begin, **characterized in that** the time interval is at least as long as the recovery time of the non-latching switching arrangement (2a, 2b), after which recovery time the non-latching switching arrangement (2a, 2b) has definitely interrupted the possibility for the current to flow through said switching arrangement after the current zero crossing.

## Revendications

1. Générateur de courant de choc d'un dispositif destiné au façonnage électromagnétique de pièces, comprenant au moins un condensateur (1) qui peut être chargé avec une polarité initiale prédéfinie, lequel peut être déchargé dans une première demi-onde de courant par le biais d'un arrangement de commutation (2a, 2b) déclenchable, laissant passer la première demi-onde de courant, à blocage en sens inverse et à autocoupure au passage par zéro du courant, à travers une bobine d'outil (3) produisant le façonnage de la pièce lors du flux de courant et avec laquelle peuvent être produites des forces agissant sur la pièce, puis chargé à une polarité inverse, un arrangement de récupération (4a, 4b) laissant passer la deuxième demi-onde de courant circulant en sens inverse, à blocage en sens inverse et possédant une inductance (4a) se trouvant en parallèle avec la bobine d'outil (3) et l'au moins un condensateur (1), au moyen duquel l'au moins un condensateur (1) peut être déchargé dans la deuxième demi-onde de courant et rechargé à la polarité initiale, l'arrangement de récupération (4a, 4b) comportant un commutateur (4b) dont la commutation est déclenchée à un écart dans le temps donné par rapport au passage par zéro de la première demi-onde de courant afin de laisser commencer le flux de courant à travers l'arrangement de récupération, **caractérisé en ce que** l'écart dans le temps est au moins égal au temps de libération de l'arrangement de commutation (2a, 2b) à autocoupure après lequel l'arrangement de commutation (2a, 2b) à autocoupure a interrompu avec certitude la possibilité de flux de courant à travers celui-ci après le passage par zéro du courant.

2. Générateur de courant de choc selon la revendication 1, **caractérisé en ce que** le circuit de récupération (4a, 4b) est commuté au moyen d'un commutateur (4b) déclenché, à autocoupure au passage par zéro du courant et à blocage en sens inverse, de préférence un thyristor (4b).

3. Générateur de courant de choc selon l'une des revendications précédentes, **caractérisé en ce que** l'amplitude du courant de la deuxième demi-onde est inférieure à celle de la première demi-onde et le temps de montée du courant de la deuxième demi-onde est supérieur à celui de la première demi-onde, notamment par sélection de l'inductance (4a) en relation avec la bobine d'outil (3).

4. Générateur de courant de choc selon l'une des revendications précédentes, **caractérisé en ce que** l'arrangement de commutation (2a, 2b) laissant passer la première demi-onde de courant, à blocage en sens inverse et à autocoupure au passage par zéro du courant est réalisé par une diode (2b) laissant passer la première demi-onde de courant, à blocage en sens inverse et un commutateur (2a) à autocoupure au passage par zéro du courant.

5. Générateur de courant de choc selon la revendication 4, **caractérisé en ce que** l'entrée de courant (3') de la bobine d'outil (3) peut être commutée de la sortie (b2') de la diode (2b) directement sur la sortie (2a') du commutateur (2a) à autocoupure au passage par zéro du courant.

6. Générateur de courant de choc selon la revendication 5, **caractérisé en ce que** lors de l'utilisation d'un commutateur (2a) à blocage en sens inverse, la sortie (b2') de la diode (2b) peut être commutée sur l'entrée (2a") du commutateur (2a).

7. Générateur de courant de choc selon la revendication 2, **caractérisé en ce que** le circuit de récupération (4a, 4b) est déclenché avec un retard dans le temps prédéfini fixe après l'instant du déclenchement de l'arrangement de commutation (2a, 2b) laissant passer la première demi-onde de courant.

8. Générateur de courant de choc selon la revendication 2, **caractérisé en ce que** le circuit de récupération (4a, 4b) est déclenché avec un retard dans le temps prédéfini fixe après le passage par zéro du courant, détecté par métrologie, de l'arrangement de commutation (2a, 2b) laissant passer la première demi-onde de courant.

9. Générateur de courant de choc selon la revendication 8, **caractérisé en ce que** la détection par métrologie (5) du passage par zéro du courant s'effectue sans contact, notamment au moyen d'une sonde de Rogowski.

10. Procédé pour faire fonctionner un générateur de courant de choc d'un dispositif destiné au façonnage électromagnétique de pièces, selon lequel au moins un condensateur (1) qui est chargé avec une polarité initiale prédéfinie, est déchargé dans une première demi-onde de courant par le biais d'un arrangement de commutation (2a, 2b) déclenché, laissant passer la première demi-onde de courant, à blocage en sens inverse et à autocoupure au passage par zéro du courant, à travers une bobine d'outil (3) produisant le façonnage de la pièce lors du flux de courant et avec laquelle peuvent être produites des forces agissant sur la pièce, puis chargé à une polarité inverse, et l'au moins un condensateur (1) est déchargé dans la deuxième demi-onde de courant puis rechargé à la polarité initiale avec un arrangement de récupération (4a, 4b) laissant passer la deuxième demi-onde de courant circulant en sens inverse, à blocage en sens inverse et possédant une inductance, lequel se trouve en parallèle avec la bobine d'outil (3) et l'au moins un condensateur (1), un commutateur à l'intérieur de l'arrangement de récupération (4a, 4b) étant commuté de manière déclenchée à un écart dans le temps donné par rapport au passage par zéro de la première demi-onde de courant afin de laisser commencer le flux de courant à travers l'arrangement de récupération, **caractérisé en ce que** l'écart dans le temps est au moins égal au temps de libération de l'arrangement de commutation (2a, 2b) à autocoupure après lequel l'arrangement de commutation (2a, 2b) à autocoupure a interrompu avec certitude la possibilité de flux de courant à travers celui-ci après le passage par zéro du courant.
